# FASCICULE DE BREVET EUROPEEN

(11) **EP 0 960 442 B1**
(45) Date de publication et mention de la délivrance du brevet: **07.09.2005**
(21) Numéro de dépôt: 98903093.7
(22) Date de dépôt: 20.01.1998
(51) Int. Cl.: H01L 31/0203, H01L 25/04, H01L 27/146

(54) **PROCEDE DE REALISATION D'UN DETECTEUR DE RAYONNEMENT PAR ASSEMBLAGE DE DALLES ELEMENTAIRES**
HERSTELLUNGSVERFAHREN EINES STRAHLUNGSDETEKTORS AUS ZUSAMMENGESETZTEN EINZELELEMENTEN
METHOD OF PRODUCING A RADIATION DETECTOR BY ASSEMBLING ELEMENTARY BLOCKS

(30) Priorité: 21.01.1997 FR 9700594
(43) Date de publication de la demande: 01.12.1999
(73) Titulaire: THALES ELECTRON DEVICES S.A., 92360 Meudon La Forêt (FR)
(72) Inventeur: VIEUX, Gérard, Thomson-CSF S.C.P.I., F-94117 Arcueil Cedex (FR); NICOLLET, André, Thomson-CSF S.C.P.I., F-94117 Arcueil Cedex (FR); SPINNLER, Vincent, Thomson-CSF S.C.P.I., F-94117 Arcueil Cedex (FR)
(74) Mandataire: Guérin, Michel
(86) Numéro de dépôt international: PCT/FR1998/000099
(87) Numéro de publication internationale: WO 1998/032180

(56) Documents cités:
- EP-A- 0 529 981
- FR-A- 2 471 610
- US-A- 4 999 484
- US-A- 5 381 014

## Description

La présente invention concerne un procédé de réalisation d'un détecteur de rayonnement à l'état solide par assemblage de dalles élémentaires unitaires pour obtenir une dalle composite de grande dimension, plus particulièrement, elle concerne un procédé de collage de ces dalles élémentaires unitaires.

L'application principale de tels détecteurs est la radiologie en rayons X. Pour fixer les idées, Dans ce qui suit, sans en limiter en quoique ce soit la portée, on se placera dans le cadre de l'application préférée de l'invention, sauf mention contraire.

Un scintillateur selon l'art connu est décrit, à titre d'exemple non limitatif, dans la demande de brevet français FR-A-2 636 800 (THOMSON-CSF).

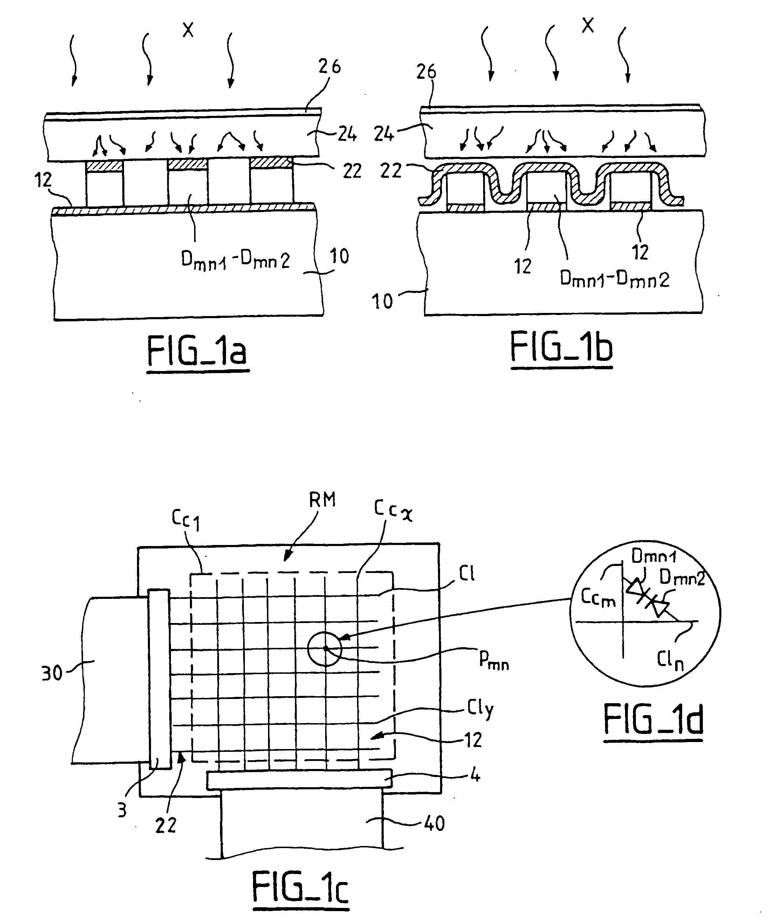

Le fonctionnement et la structure générale d'un détecteur de rayonnement X à l'état solide vont être maintenant rappelés en regard de la description des figures 1a à 3 annexées la présente description.

Selon la technologie actuelle, les détecteurs de rayonnement sont réalisés à base d'une ou plusieurs matrices d'éléments photosensibles à l'état solide. Les éléments photosensibles à l'état solide connus ne sont pas sensibles directement aux rayons de longueurs d'onde très courtes, comme le sont les rayons X. Il est nécessaire de les associer à un organe scintillateur. Celui-ci est réalisé en une substance qui a la propriété, lorsqu'elle est excitée par des rayons X, d'émettre une lumière dans une gamme de longueurs d'onde plus grandes : dans le visible (ou le proche visible). La longueur d'onde précise dépend de la substance utilisée. Le scintillateur agit donc comme un convertisseur de longueurs d'onde. La lumière visible ainsi générée est transmise aux éléments photosensibles qui effectue une conversion photoélectrique de l'énergie lumineuse reçue en signaux électriques exploitables par des circuits électroniques appropriés.

Les figures 1a et 1b représentent deux coupes latérales, orthogonales l'une à l'autre, d'une matrice d'éléments photosensibles associée classiquement à une feuille de substance scintillatrice.

Chaque élément photosensible comporte une photodiode ou un phototransistor, sensible aux photons, dans le visible ou le proche visible. A titre d'exemple, comme illustré sur les figures 1a à 1d, chaque élément photosensible est constitué, par exemple, de deux diodes, Dₘₙ₁ et Dₘₙ₂, disposées tête-bêche et le réseau matriciel RM comporte des conducteurs de colonnes, Cc₁ à Ccₓ, et des conducteurs de lignes, Cl₁ à Cl_{y}. Chacune des diodes, Dₘₙ₁ et Dₘₙ₂, constitue de manière connue, une capacité quand elle est polarisée en inverse. La première diode, Dₘₙ₁, a une capacité typiquement dix fois moins importante que la capacité de le seconde diode, Dₘₙ₂. Elle joue principalement le rôle de commutateur, alors que la seconde diode est préférentiellement photodétectrice.

A chaque croisement d'une ligne et d'une colonne, par exemple de la ligne Clₙ et de la colonne Ccₘ (voir Figure 1d), on dispose un tel ensemble de deux diodes tête-bêche, Dₘₙ₁ et Dₘₙ₂. Les diodes peuvent être remplacées par des transistors réalisés en technologie "TFT", de l'anglosaxon "Thin Film Transistor" ou "transistor en couches minces".

Les conducteurs 12 (figures 1a et 1b) sont constitués par un dépôt de métal sur un substrat isolant 10, de préférence du verre. Le dépôt est suivi d'une opération de photogravure, pour obtenir des pistes conductrices parallèles de largeur appropriée. Les diodes (par exemple, Dₘₙ₁ et Dₘₙ₂) sont formées par dépôt, sur les pistes conductrices de colonnes 12, puis gravure, des couches de silicium amorphe (Sia), intrinsèque ou dopé à l'aide de matériaux semi-conducteurs de type P ou N. Une couche très fine de matériau conducteur, de préférence transparent, est déposée sur la couche isolante 20, de manière à former, après gravure, les pistes conductrices de lignes 22 du réseau matriciel RM.

L'ensemble précédemment décrit forme ce qui est généralement appelé une "dalle de silicium amorphe" élémentaire unitaire.

Les conducteurs de lignes, Cl₁-Clₓ, et les conducteurs de colonnes, Cc₁-Cc_{y}, constituent les électrodes de polarisations des condensateurs de diodes. Ces derniers stockent des charges électriques lorsqu'elles sont soumises à un rayonnement lumineux et délivrent un signal électrique, proportionnel à la charge stockée, lorsqu'elles sont polarisées électriquement. L'adressage des conducteurs de lignes, Cl₁-Clₓ, et des conducteurs de colonnes, Cc₁-Cc_{y}, s'effectue selon une chronologie appropriée, de manière à ce que tous les pixels pₘₙ soient polarisés séquentiellement dans un ordre prédéterminé. Le signal délivré par chaque pixel pₘₙ est ainsi récupéré et traité par des circuits électroniques (non représentés), de façon à reconstituer (point par point) l'image stockée sous forme de charges électriques.

Les signaux sont récupérés dans des zones de connectique respectives, 3 et 4, pour les lignes, Cl₁-Clₓ, et les colonnes, Cc₁-Cc_{y}. Les connexions avec les circuits électroniques externes peuvent être réalisées à l'aide de câbles souples multiconducteurs, 30 et 40, respectivement.

On doit généralement prévoir des séquences dites de "remise à niveau optique" des pixels pₘₙ, une fois que les signaux ont été délivrés par ceux-ci. La chronologie des signaux d'adressage est adaptée en conséquence. On insère, entre les signaux de lecture des séquences de remise à niveau optique. Elles consistent à effectuer un éclairement généralisé des pixels Pₘₙ, après lecture. Ces séquences ont pour objet de rétablir un état de référence électrique sur les pixels pₘₙ qui ont été perturbés au cours des phases de stockage et de lecture des charges.

Cet éclairement généralisé est effectué par la face arrière de la dalle de verre 10, laquelle doit être suffisamment transparente aux longueurs d'onde de la lumière utilisée.

Comme il a été indiqué, les éléments photosensibles doivent être illuminés par de la lumière visible (ou dans une gamme proche de la lumière visible). Il est nécessaire de disposer d'un scintillateur qui convertit les rayons X en énergie lumineuse, dans le spectre des longueurs d'ondes visibles. Pour ce faire, il suffit de recouvrir la dalle silicium amorphe, précédemment décrite, d'une couche de substance scintillatrice 24. A titre d'exemple, pour un détecteur sensible aux rayons X de l'ordre de 60 KeV, on utilise comme substance scintillatrice de l'iodure de césium (CsI) dopé à l'iodure de sodium (NaI) ou de thallium (TiI), selon que l'on souhaite obtenir un signal lumineux de longueur d'onde 390 nm ou 550 nm, respectivement.

La dalle de silicium amorphe qui vient d'être décrite est réalisée par évaporation sous vide de couches minces de matériaux sur la dalle de verre. Les dimensions de la dalle de verre doivent être compatibles avec les capacités dimensionnelles actuelles des machines de réalisation du dépôt.

Or, le besoin s'est fait sentir de disposer de dalles de grandes dimensions, ces dimensions étant incompatibles avec les machines de dépôt précitées. Aussi, il est nécessaire d'avoir recours à des dalles élémentaires unitaires, de plus petites dimensions, qui sont assemblées par juxtaposition les unes par rapport aux autres. À titre d'exemple non limitatif, on assemble un damier de quatre dalles unitaires élémentaires pour former une dalle composite de grande dimension. Un tel procédé d'assemblage est décrit, par exemple, dans la demande de brevet français FR-A-2 687 494 (THOMSON TUBES ELECTRONIQUES). Les dalles unitaires conservent leur autonomie en ce qui concerne l'adressage de leurs propres pixels pₘₙ.

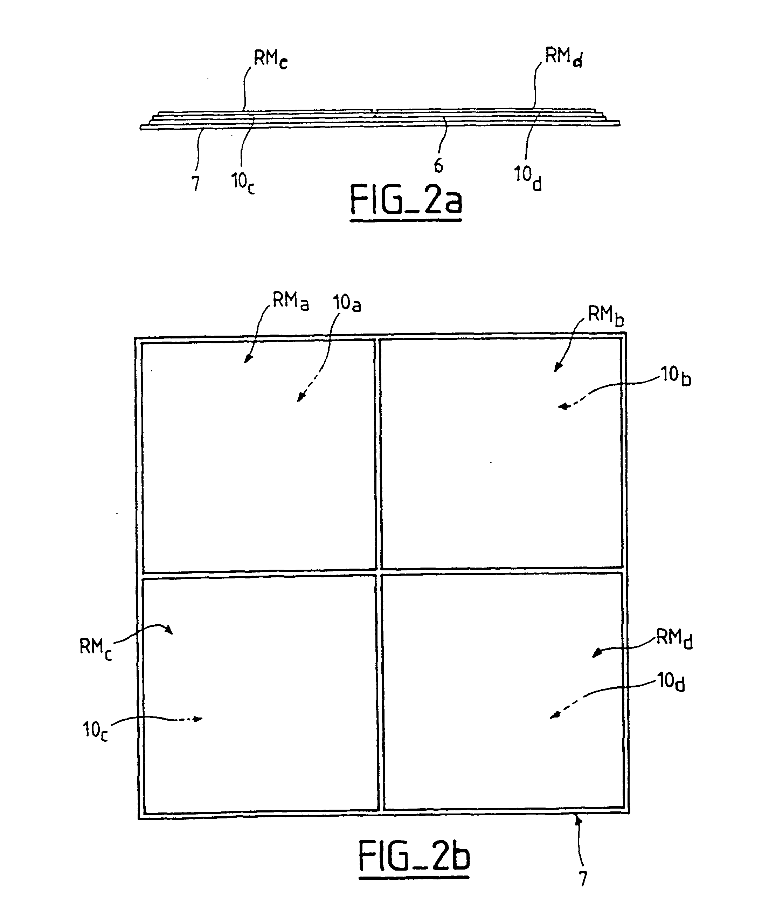

Les figures 2a et 2b, annexées à la présente description, illustrent un tel assemblage, respectivement en vue de côté et de dessus. Dans l'exemple décrit, la dalle composite de grande dimension comprend quatre dalles élémentaires unitaires, 10ₐ à 10_{d}.

Les dalles élémentaires unitaires, 10ₐ à 10_{d}, sont découpées précisément sur deux côtés de leur périphérie libres de la zone de connectique (non représentée), afin que les zones actives de pixels, RMₐ à RM_{d}, affleurent au bord de la dalle découpée. Les dalles découpées, 10ₐ à 10_{d}, sont ensuite positionnées les unes par rapport aux autres afin de préserver la continuité de la zone active de pixels et leur pas, d'une dalle à l'autre.

L'assemblage est réalisé par collage (film 6) d'un support commun 7 sur les dalles découpées et positionnées, 10ₐ à 10_{d}. Ce support 7 doit être également suffisamment transparent à la lumière visible afin d'autoriser la remise à niveau optique des pixels de l'ensemble des dalles unitaires ainsi assemblées.

La méthode la plus simple de réalisation du scintillateur est de déposer une couche d'iodure de césium (CsI) dopée sur un substrat quelconque, de recuire ce substrat afin d'obtenir les propriétés de luminescence désirées et de rapporter cet ensemble, scintillateur-substrat contre l'ensemble collé. Le scintillateur peut être rapporté ou couplé optiquement sur la dalle par collage.

Les performances obtenues avec un scintillateur ainsi réalisé sont toutefois moyennes, notamment en terme de résolution. On observe en effet une réfraction de la lumière visible issue du scintillateur, soit dans l'épaisseur de la colle dans le cas du couplage sur la dalle, soit dans l'épaisseur de la lame d'air difficile à maîtriser dans le cas du plaquage sur la dalle.

Une autre méthode de réalisation du scintillateur consiste à réaliser le scintillateur par évaporation directe d'une substance scintillatrice sur la dalle composite obtenue par l'assemblage et le collage des dalles élémentaires, 10ₐ à 10_{d}. Cette solution présente l'avantage d'un scintillateur en contact intime avec cette dalle composite. La diffusion de la lumière à l'interface scintillateur/dalle et la perte de résolution qui en résulte sont minimisées.

L'assemblage collé ainsi obtenu devra subir des contraintes environnementales, thermiques et mécaniques. Il doit résister aux chocs vibrations et secousses. Le film de colle 6 doit être suffisamment souple pour résister à ces contraintes mécaniques. Afin de permettre la remise à niveau optique des pixels pₘₙ par la face arrière des dalles, 10ₐ à 10_{d}, le film de colle 6 doit par ailleurs être suffisamment transparent à la lumière visible utilisée pour cette remise à niveau optique.

Enfin, lorsque le scintillateur est réalisé par évaporation directe, l'assemblage collé subit un recuit de luminescence de la couche d'iodure de césium (CsI). Le film de colle doit donc supporter la température de recuit. Il doit être également être suffisamment souple pour supporter des différences de coefficients de dilatation des matériaux à coller (dalles unitaires 10ₐ à 10_{d} et support commun 7) qui sont, a priori, différents.

Pour répondre à ces exigences, on peut utiliser une résine silicone bicomposant qui se polymérise par polyaddition, pour assurer le collage.

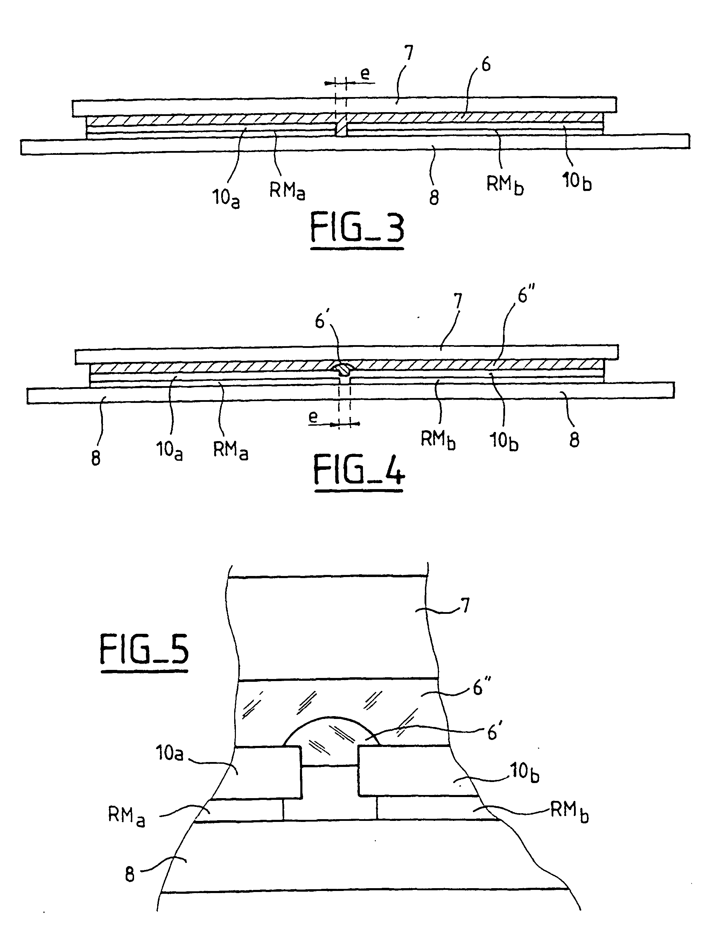

Les détecteurs de grande dimension multidalles, réalisés selon le procédé qui vient d'être rappelés, comprennent donc les étapes suivantes, illustré schématiquement en regard de la figure 3 annexée à la présente description :
a/ on positionne sur un substrat 8 (dit de positionnement) des dalles élémentaires unitaires, 10ₐ à 10_{d} (dont seules deux, 10ₐ et 10_{b}, sont visibles sur la figure 3), les unes par rapport aux autres : le pas des pixels pₘₙ doit être respecté, les espaces inter-dalles e étant typiquement compris dans la gamme 10 à 100 µm ;
b/ on répand un film de colle 6 sur l'ensemble ainsi constitué ;
c/ le support commun 7 est ensuite posé sur l'ensemble.

Ce procédé présente cependant des inconvénients. En effet, du fait de la fluidité de la colle, celle-ci pénètre le plus souvent entre les dalles élémentaires unitaires (dans les espaces e) et se répand sur leurs faces recouvertes des dépôts semi-conducteurs (par exemple les réseaux matriciels RMₐ et RM_{b} visibles sur la figure 3).

Ce problème doit être évité. La dégradation de l'état de propreté et la topographie qui en résultent sont incompatibles avec le dépôt de la substance scintillatrice sur l'ensemble des dalles élémentaires unitaires, que ce soit dans le cas d'un scintillateur rapporté ou dans le cas d'un scintillateur réalisé par évaporation directe.

L'invention se fixe pour but de pallier les inconvénients qui résultent des procédés de réalisation de détecteurs selon l'art connu.

Pour ce faire, le collage selon le procédé de l'invention est réalisé en deux temps. Dans un premier temps les espaces inter-dalles sont colmatés par un premier type de colle, sans les remplir entièrement. Dans un second temps, le collage proprement dit est réalisé en utilisant un second type de colle.

L'invention concerne donc un Procédé de réalisation d'un détecteur de rayonnement constitué par l'association d'un organe photosensible et d'un scintillateur, ledit organe photosensible étant constitué d'au moins deux dalles élémentaires unitaires, chaque dalle élémentaire unitaire comportant une pluralité d'éléments actifs ou pixels et les bords de deux dalles contiguës étant séparés par un espace inter-dalles déterminé, le procédé comprenant au moins les phases suivantes :
a/ juxtaposition desdites dalles élémentaires unitaires sur un substrat de positionnement pour former une dalle composite de plus grande dimension dont les dalles élémentaires unitaires sont séparées les unes des autres par ledit espace inter-dalles déterminé, ladite pluralité d'éléments actifs ou pixels étant disposée en contact avec le substrat de positionnement ;
b/ collage de ladite dalle composite sur un support commun;
caractérisé en ce que ladite phase de collage comprend, en séquence :
- une première étape de collage consistant à colmater lesdits espaces inter-dalles déterminés par formation d'un cordon de colle laissant une zone libre entre son extrémité inférieure et ledit substrat de positionnement ;
- et une seconde étape de collage consistant à répandre un film de colle recouvrant lesdites dalles élémentaires unitaires et ledit cordon de colle de colmatage.

Avantageusement, la colle utilisée dans la première étape est une colle à viscosité élevée (dans les conditions de température et de pression ambiantes) et la colle utilisée dans la deuxième étape est une colle de viscosité beaucoup plus faible (colle fluide dans les conditions de dépôt). Ainsi, le cordon de colle déposée à la première étape peut jouer le rôle de bouchon remplissant la partie supérieure des interstices entre dalles, et la deuxième couche de colle ne pénètre pas dans ces interstices.

Le brevet US-A-4 999 484 décrit un capteur d'image qui n'utilise pas une double étape de collage.

Le brevet US-A-5 381 014 décrit un capteur d'image à rayons X à éléments juxtaposés.

L'invention sera mieux comprise et d'autres caractéristiques et avantages apparaîtront à la lecture de la description qui suit en référence aux figures annexées, et parmi lesquelles :
- les figures 1a à 2b illustrent schématiquement le fonctionnement et la structure d'un détecteur de radiographie selon l'art connu;
- la figure 3 illustre, par référence à un détecteur de grande dimension constitué de plusieurs dalles élémentaires, un procédé de collage de ces dalles selon l'art connu ;
- la figure 4 illustre le procédé de collage selon l'invention ;
- la figure 5 est un détail agrandi d'un détecteur obtenu selon le procédé de collage de l'invention.

Les figures 4 et 5 illustrent un exemple réalisation d'un détecteur réalisé selon l'invention.

La structure générale d'un détecteur de grande dimension, telle qu'elle a été rappelée en regard des figures 1a à 3, est conservée. Les éléments communs avec le détecteur de l'art connu de la figure 3 portent les mêmes références et ne seront redécrits qu'en tant que de besoin.

Selon une caractéristique importante de l'invention, le collage comporte désormais deux étapes distinctes successives.

La première étape de collage a pour but de colmater les espaces inter-dalles e, sans les remplir entièrement. Pour ce faire, dans une variante préférée de l'invention, on utilise un premier type de colle constituée par un matériau à forte viscosité (ou à la rigueur un matériau thixotrope).

La figure 5 illustre plus particulièrement, de façon agrandie, une zone inter-dalles e. On constate que, à la suite de la première étape de collage, se forme un cordon de colle 6' réunissant les bords supérieurs de deux dalles adjacentes 10a et 10b. Ce cordon laisse subsister entre sa paroi inférieure et le substrat de positionnement 8, une zone non remplie Z. Ce cordon 6', qui ne remplit donc que la zone supérieure de l'espace inter-dalles e, va jouer le rôle de "bouchon" pour la colle répandu lors de la seconde étape de collage.

La seconde étape de collage a pour objet de réaliser le collage proprement dit. Elle s'apparente à l'étape unique de collage selon l'art connu. On utilise pour ce faire un second type de colle, suffisamment fluide pour qu'elle puisse se répandre sur la surface supérieure de l'ensemble des dalles élémentaires unitaires et de leurs couches de semi-conducteur amorphe (réseaux matriciels de pixels), 10ₐ-RMₐ à 10_{d}-RM_{d} (voir figure 2b). On obtient alors un film superficiel de colle 6".

L'étape suivante, pour la réalisation du détecteur, consiste en la pose du support commun sur le film superficiel de colle 6". Cette étape est identique à l'étape correspondante de l'art connu.

Naturellement, les colles utilisées doivent satisfaire aux différentes exigences et contraintes précédemment rappelées : notamment, transparence optique à la lumière visible, souplesse mécanique et tenue en température dans le cas d'un scintillateur réalisé par évaporation directe.

Enfin, les deux types de colles doivent être compatibles entre elles.

Pour la première étape, on peut utiliser un gel ou une résine thixotrope ayant les propriétés requises de souplesse, de transparence optique et de résistance en température (si nécessaire).

Pour la seconde étape, on peut utiliser une résine silicone bi-composant. Cette résine se polymérise par polyaddition. Elle satisfait, après polymérisation, les exigences énoncées ci-dessus.

Selon une seconde variante du procédé de l'invention, on peut utiliser la même résine silicone bicomposant, mais à des degrés de polymérisation différemment avancés. On utilise une colle partiellement polymérisée pour la première étape, de sorte qu'elle soit suffisamment visqueuse pour ne pas remplir les espaces inter-dalles jusqu'au fond de ceux-ci et former les cordons 6'. Le temps nécessaire de prépolymérisation dépend naturellement de la température. A titre d'exemple, pour une température de l'ordre de 35 °C, le temps de prépolymérisation est de deux heures environ. On utilise ce même type de colle, mais non polymérisée, pour la seconde étape. Celle-ci, étant à l'état fluide, se répand donc sur la face supérieure des dalles, par exemple 10ₐ et 10_{b}, pour former le film uniforme 6".

Ensuite, le processus de polymérisation se poursuit.

A la lecture de ce qui précède, on constate aisément que l'invention atteint bien les buts qu'elle s'est fixés.

Tout en conservant les avantages des procédés de collage selon l'art connu, qui satisfont notamment aux exigences de transparence optique, de souplesse mécanique et de tenue éventuelle en température, le procédé selon l'invention permet en outre d'interdire toute pollution et toute perturbation topologique de la face des dalles sur laquelle va être réalisé le scintillateur.

Il doit être clair cependant que l'invention n'est pas limitée aux seuls exemples de réalisations précisément décrits, notamment en relation avec les figures 4 et 5. En particulier, le nombre de dalles assemblées peut être différent de quatre, ce qui correspond à une configuration matricielle classique (2X2 dalles). Ce nombre est au minimum égal à deux.

## Revendications

1. Procédé de réalisation d'un détecteur de rayonnement constitué par l'association d'un organe photosensible et d'un scintillateur (24), ledit organe photosensible étant constitué d'au moins deux dalles élémentaires unitaires (10ₐ, 10_{b}), chaque dalle élémentaire unitaire comportant une pluralité d'éléments actifs ou pixels (RMₐ, RM_{b}) et les bords de deux dalles contiguës étant séparés par un espace inter-dalles déterminé (e), le procédé comprenant au moins les phases suivantes :
a/ juxtaposition desdites dalles élémentaires unitaires (10ₐ, 10_{b}) sur un substrat de positionnement (8) pour former une dalle composite de plus grande dimension dont les dalles élémentaires unitaires sont séparées les unes des autres par ledit espace inter-dalles déterminé (e), ladite pluralité d'éléments actifs ou pixels (RMₐ, RM_{b}) étant tournées vers le substrat de positionnement ;
b/ collage de ladite dalle composite sur un support commun (7);
**caractérisé en ce que** ladite phase de collage comprend, en séquence :
- une première étape de collage consistant à colmater lesdits espaces inter-dalles déterminés (e) par formation d'un cordon de colle (6') laissant une zone libre entre son extrémité inférieure et ledit substrat de positionnement (8) ;
- et une seconde étape de collage consistant à répandre un film de colle (6") recouvrant lesdites dalles élémentaires unitaires (10ₐ, 10_{b}) et ledit cordon de colle de colmatage (6').

2. Procédé selon la revendication 1, **caractérisé en ce que** la colle utilisée dans la première étape est une colle à viscosité élevée, et la colle utilisée dans la deuxième étape est une colle de viscosité beaucoup plus faible.

3. Procédé selon la revendication 2, **caractérisé en ce que** la colle utilisée pour réaliser ledit colmatage (6') de la première étape est un gel ou une résine silicone thixotrope.

4. Procédé selon la revendication 1, **caractérisé en ce que** la colle répandue pendant la seconde étape de collage pour former ledit film (6") est une résine silicone bicomposant, polymérisable par polyaddition.

5. Procédé selon la revendication 1, **caractérisé en ce que** la colle utilisée pour réaliser ledit colmatage (6') de la première étape et la colle répandue pendant la seconde étape de collage pour former ledit film (6") sont toutes deux à base de résine silicone bicomposant, polymérisable par polyaddition, **en ce que** la première étape de collage consiste à introduire, dans lesdits espaces inter-dalles déterminés (e), de la résine partiellement polymérisée, de manière à ce qu'elle ne pénètre pas jusqu'au fond de ces espaces inter-dalles, et **en ce que** la seconde étape de collage consiste à répandre, sur la surface de ladite dalle composite, de la résine non encore polymérisée, de manière à ce qu'elle soit à l'état fluide pour obtenir un étalement uniforme.

## Patentansprüche

1. Verfahren zur Herstellung eines Strahlungsdetektors, der aus der Vereinigung eines lichtempfindlichen Organs und eines Szintillators (24) besteht, wobei das lichtempfindliche Organ aus mindestens zwei einzelnen Elementarplatten (10ₐ, 10_{b}) besteht, wobei jede einzelne Elementarplatte mehrere aktive Elemente oder Pixel (RMₐ, RM_{b}) aufweist, und die Ränder von zwei aneinander grenzenden Platten durch einen bestimmten Plattenzwischenraum (e) getrennt werden, wobei das Verfahren mindestens die folgenden Phasen aufweist:
a/ Nebeneinanderanordnung der einzelnen Elementarplatten (10ₐ, 10_{b}) auf einem Positonierungssubstrat (8) zur Bildung einer Verbundplatte größerer Abmessung, deren einzelne Elementarplatten voneinander durch den bestimmten Plattenzwischenraum (e) getrennt sind, wobei die mehreren aktiven Elemente oder Pixel (RMₐ, RM_{b}) zum Positionierungssubstrat hin weisen;
b/ Kleben der Verbundplatte auf einen gemeinsamen Träger (7);
**dadurch gekennzeichnet, dass** die Phase des Klebens in der Reihenfolge aufweist:
- einen ersten Klebeschritt, der darin besteht, die bestimmten Plattenzwischenräume (e) durch Bildung eines Klebstoffwulsts (6') zu verfüllen, der eine freie Zone zwischen seinem unteren Ende und dem Positionierungssubstrat (8) lässt; und
- einen zweiten Klebeschritt, der darin besteht, eine dünne Klebstoffschicht (6") zu verstreichen, die die einzelnen Elementarplatten (10ₐ, 10_{b}) und den Verfüllungs-Klebstoffwulst (6') bedeckt.

2. Verfahren nach Anspruch 1, **dadurch gekennzeichnet, dass** der im ersten Schritt verwendete Klebstoff ein Klebstoff mit hoher Viskosität und der im zweiten Schritt verwendete Klebstoff ein Klebstoff mit wesentlich geringerer Viskosität ist.

3. Verfahren nach Anspruch 2, **dadurch gekennzeichnet, dass** der zur Herstellung der Verfüllung (6') des ersten Schritts verwendete Klebstoff ein Gel oder ein thixotropes Siliconharz ist.

4. Verfahren nach Anspruch 1, **dadurch gekennzeichnet, dass** der während des zweiten Klebeschritts zur Bildung der dünnen Schicht (6") verstrichene Klebstoff ein durch Polyaddition polymerisierbares Zweikomponenten-Siliconharz ist.

5. Verfahren nach Anspruch 1, **dadurch gekennzeichnet, dass** der zur Herstellung der Verfüllung (6') des ersten Schritts verwendete Klebstoff und der während des zweiten Klebeschritts zur Bildung der dünnen Schicht (6") verstrichene Klebstoff beide auf der Basis eines durch Polyaddition polymerisierbaren Zweikomponenten-Siliconharzes sind, dass der erste Klebeschritt darin besteht, in die bestimmten Plattenzwischenräume (e) teilweise polymerisiertes Harz derart einzubringen, dass es nicht bis zum Grund dieser Plattenzwischenräume eindringt, und dass der zweite Klebeschritt darin besteht, auf die Oberfläche der Verbundplatte noch nicht polymerisiertes Harz aufzubringen, damit es im fluiden Zustand ist, um ein gleichmäßiges Verstreichen zu erhalten.

## Claims

1. Process for producing a radiation detector consisting of the combination of a photosensitive component and a scintillator (24), the said photosensitive component consisting of at least two unitary elementary slabs (10ₐ, 10_{b}), each unitary elementary slab containing a plurality of active elements or pixels (RMₐ, RM_{b}) and the edges of two adjacent slabs being separated by a determined inter-slab space (e), the process comprising at least the following phases:
a/ juxtaposition of the said unitary elementary slabs (10ₐ, 10_{b}) on a positioning substrate (8) in order to form a composite slab of larger size whose unitary elementary slabs are separated from one another by the said determined inter-slab space (e), the said plurality of active elements or pixels (RMₐ, RM_{b}) being turned towards the positioning substrate;
b/ adhesively bonding the said composite slab onto a common support (7);
**characterized in that** the said adhesive-bonding phase comprises, in sequence:
- a first adhesive-bonding step consisting in sealing the said determined inter-slab spaces (e) by forming a bead of adhesive (6'), leaving a free zone between its lower end and the said positioning substrate (8);
- and a second adhesive-bonding step consisting in spreading a film of adhesive (6'') covering the said unitary elementary slabs (10ₐ, 10_{b}) and the said bead of sealing adhesive (6').

2. Process according to Claim 1, **characterized in that** the adhesive used in the first step is a high-viscosity adhesive, and the adhesive used in the second step is an adhesive with much lower viscosity.

3. Process according to Claim 2, **characterized in that** the adhesive used to carry out the said sealing (6') in the first step is a thixotropic silicon resin or gel.

4. Process according to Claim 1, **characterized in that** the adhesive spread during the second adhesive-bonding step in order to form the said film (6'') is a two-component silicon resin which can be polymerized by polyaddition.

5. Process according to Claim 1, **characterized in that** the adhesive used to carry out the said sealing (6') in the first step and the adhesive spread during the second adhesive-bonding step in order to form the said film (6'') are both based on two-component silicon resin which can be polymerized by polyaddition, and **in that** the first adhesive-bonding step consists in introducing partially polymerized resin into the said determined inter-slab spaces (e) so that it does not penetrate as far as the bottom of these inter-slab spaces, and **in that** the second adhesive-bonding step consists in spreading as yet unpolymerized resin over the surface of the said composite slab, so that it is in the fluid state in order to obtain uniform spreading.
